Europäisches Patentamt

European Patent Office

Office européen des brevets

(19)

(11) Numéro de publication: **0 252 818**
**A1**

(12) **DEMANDE DE BREVET EUROPEEN**

(21) Numéro de dépôt: 87401543.1

(22) Date de dépôt: 02.07.87

(51) Int. Cl.4: **H 01 L 47/02**
**H 01 L 29/36**

(30) Priorité: 09.07.86 FR 8609976

(43) Date de publication de la demande:
13.01.88 Bulletin 88/02

(84) Etats contractants désignés: **DE GB IT NL**

(71) Demandeur: **THOMSON-CSF**
**173, Boulevard Haussmann**
**F-75379 Paris Cédex 08 (FR)**

(72) Inventeur: **Diamand, Félix**
**THOMSON-CSF SCPI 19, avenue de Messine**
**F-75008 Paris (FR)**

(74) Mandataire: **Turièque, Clotilde et al**
**THOMSON-CSF SCPI 19, avenue de Messine**
**F-75008 Paris (FR)**

(54) **Diode à transfert d'électrons, à régions balistiques périodiques.**

(57) L'invention se rapporte à une nouvelle structure de diode à transfert d'électrons. Elle comporte un substrat (1) une couche métallique formant le contact de cathode (K), une couche de semi-conducteur d'entrée dopée N, (12), et une structure périodique composée de cellules élémentaires (10, 20, 30); chaque cellule comporte une région dopée courte balistique (11) délimitée de part et d'autre par une couche très mince, respectivement P$^+$ (12) et N$^+$ (13), et suivie d'une région de transit (14) de matériau homogène dopée N. Dans les régions balistiques courtes, les électrons acquièrent l'énergie nécessaire au transfert de la bande (Γ) à la bande (L) dans un temps inférieur au temps de collision, puis les régions de transit permettent de thermaliser les électrons qui abordent la région balistique suivante avec une énergie moyenne toujours égale. Un contact métallique d'anode (A) est prévu sur la dernière région de transit.

Application aux diodes à transfert de charges à hautes performances travaillant dans la bande millimétrique.

FIG_4

EP 0 252 818 A1

## Description

Diode à transfert d'électrons, à régions balistiques périodiques.

L'invention se rapporte au domaine des semiconducteurs et plus particulièrement à une diode à transfert d'électrons.

Les diodes à transfert d'électrons, ou diodes à effet Gunn, sont couramment utilisées dans les équipements hyperfréquences. Leur faible bruit d'oscillateur, leur robustesse, leur faible encombrement, leur coût modique et leur tension de polarisation réduite les désignent tout particulièrement comme oscillateur local ou comme source d'émission dans les radars, radars Doppler, et certains faisceaux hertziens. Depuis une dizaine d'années, les performances ont été poussées jusqu'à la bande des ondes millimétriques. Des diodes à phosphure d'indium InP ont donné, en continu, jusqu'à 250 mW à 56 GHz, 125 mW à 94 GHz, avec des rendements respectifs de 8% et 4%.

L'invention vise à améliorer les performances des diodes à effet Gunn millimétriques. Pour cela, une nouvelle structure de diode à transfert d'électrons est proposée, pour la bande millimétrique, dont l'objectif est de remédier aux défauts des diodes Gunn qui limitent leurs performances: zone morte, phénomènes de relaxation et résistance des contacts notamment.

Suivant l'invention une diode à transfert d'électrons comportant un substrat semi-conducteur dopé $N^+$ dont une face est munie d'un contact métallique formant la cathode et dont l'autre face est recouverte d'une couche d'entrée de semi-conducteur dopée N suivie d'une structure semiconductrice active munie d'un contact métallique formant l'anode, est caractérisée en ce que la structure semi-conductrice comporte au moins une cellule élémentaire comportant une région courte balistique dopée N, entre deux couches semi-conductrices très minces, fortement dopées respectivement $P^+$ et $N^+$, et une région de transit dopée N, plus longue, la région balistique permettant d'amener les électrons à un niveau d'énergie élevé dans un temps inférieur au temps de collision, et la région de transit permettant de ramener l'énergie électronique, par relaxation avec le réseau, à une valeur très inférieure à l'énergie de transfert.

L'invention sera mieux comprise et d'autres caractéristiques apparaîtront à l'aide de la description qui suit, en référence aux figures annexées;

La figure 1 représente le diagramme d'énergie $\varepsilon$ de la bande de conduction;

La figure 2 représente la vitesse électronique stationnaire en fonction du champ électrique pour l'arséniure de gallium.

La figure 3 représente en pointillés la caractéristique courant-tension de la diode dans des conditions idéalisées et en trait plein une caractéristique dynamique en mode d'accumulation;

La figure 4 est un schéma de la diode à transfert d'électrons selon l'invention;

Les figures 5a, 5b et 5c représentent respectivement une cellule élémentaire de la diode selon l'invention et les profils de charge et de champ électrique associés.

Les figures 6a et 6b représentent respectivement la tension et le courant en fonction du temps dans la région balistique.

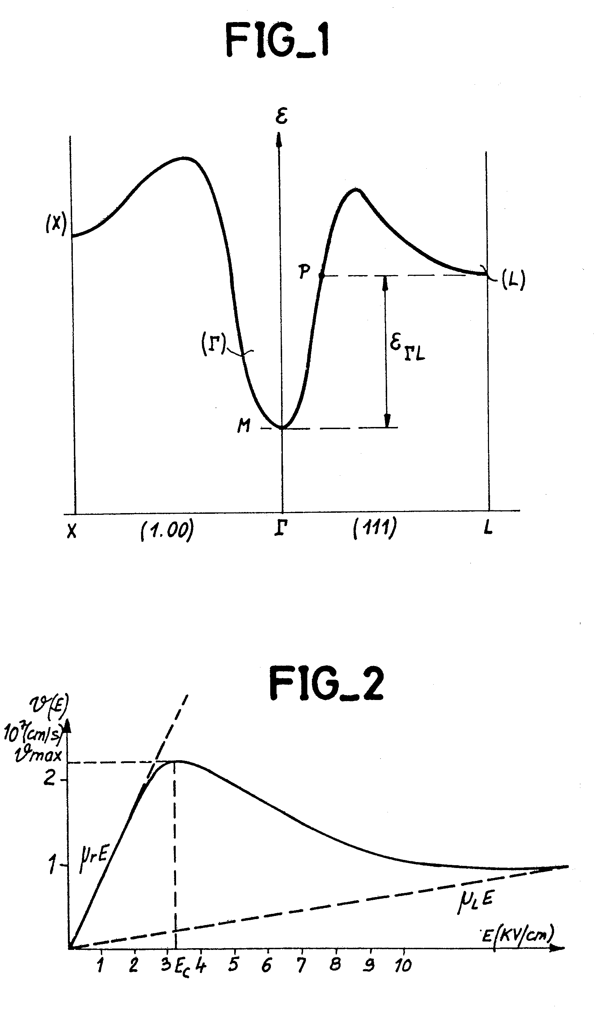

L'effet Gunn millimétrique est un effet de résistance négative de volume que l'on observe dans certains composés III-V, par exemple l'arséniure de gallium GaAs ou le phosphure d'indium, InP. Il trouve son origine dans le transfert d'électrons de la bande de conduction, sous l'effet du champ électrique, d'une vallée à forte mobilité vers une vallée à faible mobilité. Le diagramme des niveaux d'énergie $\varepsilon$ en fonction des vecteurs d'onde $\vec{k}$, $\varepsilon(\vec{k})$ de la bande de conduction est représenté sur la figure 1. Il se compose de plusieurs sous-bandes. La sous-bande la plus basse en énergie, dans le cas de l'arséniure de gallium GaAs et du Phosphure d'Indium l'InP auxquels on se limite ici, est la vallée ($\Gamma$) centrée en k = 0. En montant dans l'échelle des énergies, la sous-bande suivante (L) se compose de quatre vallées équivalentes, suivant les quatre axes équivalents <111>. Comme il est connu, l'écart entre les vallées ($\Gamma$) et (L) est l'énergie de transfert $\varepsilon_{\Gamma L}$, égale à 0,33eV pour le GaAs et 0,54eV pour l'InP. La sous-bande suivante X a peu d'influence et sera négligée. La masse effective des électrons dans la sous-bande (L) est nettement plus grande que celle des électrons dans la sous-bande ($\Gamma$). Il en est donc de même des densités des niveaux, alors que la mobilité est nettement plus faible dans la sous-bande (L), $\mu_L$, que dans la sous-bande ($\Gamma$), $\mu_\Gamma$.

La figure 2 représente, pour l'arséniure de gallium GaAs, la caractéristique v(E), vitesse électronique stationnaire dans un champ constant E. Suivant des valeurs croissantes de E, à partir de E = 0, on observe d'abord la caractéristique ohmique $v = \mu_\Gamma E$: tous les électrons sont dans la vallée principale, leur énergie moyenne est à peu près égale à $\frac{3}{2}$ KT où T est la température du réseau, et K constante de Boltzmann. Pour E un peu plus grand, l'électron reçoit, entre deux chocs, plus d'énergie qu'il ne peut en céder lors d'un choc et l'énergie moyenne est supérieure à $\frac{3}{2}$KT: une tendance à la saturation apparaît, liée d'une part à une diminution de $\mu_\Gamma$, d'autre part à un début de transfert de la bande ($\Gamma$) à la bande (L). Cependant pour E = 2 500 V/cm, la population de la vallée (L) représente encore moins de 2%. Pour E supérieur à 2 500 V/cm, la valeur moyenne de l'énergie croît plus fortement avec E, le transfert de la bande ($\Gamma$) à la bande (L) s'accentue, d'où une baisse de la mobilité moyenne $\mu$: $\mu = (n_\Gamma \mu_\Gamma + n_L \mu_L)./n$, où $n_\Gamma$, $n_L$ et n sont respectivement les nombres d'électrons dans la sous-bande ($\Gamma$) dans la sous-bande (L) et n le nombre total. La vitesse passe par un maximum $v_{max}$ pour le champ critique $E_c$ à peu près égal à 3 200 V/cm. Pour un champ électrique E supérieur au champ critique $E_c$, $n_L$ augmente au point que v(E) a une pente négative. Enfin pour un champ électrique E très supérieur au champ critique $E_c$, la majorité des électrons est dans les vallées (L) de sorte que la courbe v(E) tend vers la droite $v = /\mu_L E$. Pour le phosphure d'indium InP, le champ critique $E_c$ est plus élevé, 10 kV/cm, ainsi que la vitesse maximale $v_{max}$, ce qui s'explique par la valeur plus grande de l'énergie de transfert (0,54 eV) et un temps de relaxation de l'énergie plus court.

Il n'existe pas de modèle simple pour un oscillateur à transfert d'électrons, mais l'explication ci-après permet une approche du fonctionnement dans des conditions idéalisées.

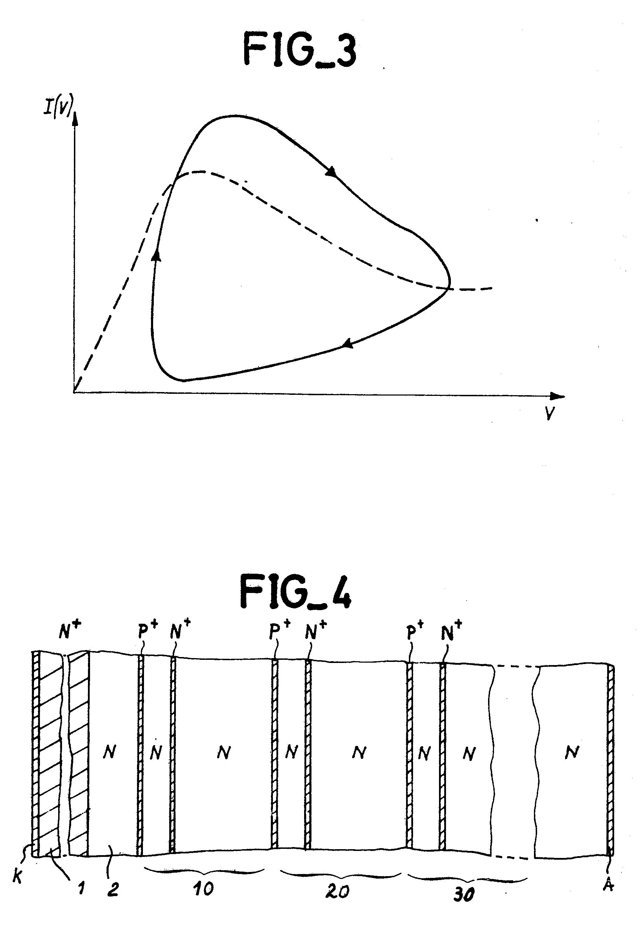

Plusieurs modes de fonctionnement sont possibles selon les valeurs des paramètres physiques de la diode et du circuit. Avec une couche de GaAs homogène, de type N, munie de deux contacts, le contact cathodique étant supposé ni injectant ni limitant, l'admission de courant dans la diode préserve la neutralité de charge et donc le maintien du champ électrique à la même valeur dans tout le volume de la couche. Ces conditions idéales peuvent être approchées dans une plage de courant étroite, au moyen d'un contact Schottky à faible barrière. Si l'on suppose de plus que ces conditions sont réalisées à tout instant du cycle HF, alors la caractéristique de courant en fonction de la tension, I(V), de la diode se déduit de la courbe v(E) simplement par affinité, $I(V) = qNv(\frac{V}{d})$, où d est l'épaisseur de la couche et N le dopage, c'est-à-dire la densité des charges fixes et mobiles. La figure 3 présente cette caractéristique en pointillés. En choisissant le point de polarisation vers le milieu de la région à pente négative, la diode se comporte comme une résistance négative pour un signal HF, la réactance étant négligeable.

Ce modèle néglige l'influence des contacts, les instabilités de charge d'espace, les effets de transit, le courant de déplacement, et les mécanismes de relaxation qui consituent des limitations majeures aux très hautes fréquences :

- Le contact cathodique crée une inhomogénéité de charge dans son voisinage qui forme le centre d'une instabilité de charge d'espace si le champ est supérieur au champ critique. Le type d'instabilité dépend de la nature du contact. Un contact ohmique $N^+$ - N est un contact injectant qui crée un excès d'électrons à l'entrée de la zone active, ce qui favorise la formation d'un domaine d'accumulation. Un contact Schottky à faible barrière, polarisé en inverse, est au contraire un contact limitant qui entraîne la formation d'un domaine dipolaire. Les taux de croissance de ces deux types d'instabilité sont différents, le plus rapide celui d'un domaine d'accumulation. La croissance d'un domaine dipolaire est ralentie du fait de la déplétion de charge liée au contact limitant. Dans le cas d'une diode millimétrique, pour un temps de transit de l'ordre de $10^{-11}$s, pour $N = 5.10^{15}$ porteurs par cm$^3$, le développement du domaine dipolaire est incomplet. Un fonctionnement de ce type, sans groupement notable de charge, est compatible avec de bonnes performances: les meilleurs puissances et rendements à 94 GHz connus ont été obtenus avec des contacts limitants sur des diodes à phosphure d'indium, InP comme décrit par Y.D Crowley et F.B. Fank dans un article intitulé "Millimeter Wave InP Gunn Devices", 4.INST Measur.T.E 1984, vol.18, p.11.

- Les mécanismes de relaxation qui limitent les performances des diodes millimétriques sont de deux sortes. En premier lieu, il y a la force d'inertie qui fait que l'électron répond avec retard à une variation spatiale ou temporelle du champ électrique. Ce retard est caractérisé par le temps d'accélération-décélération $\tau_{ad}$. En second lieu, il y a la relaxation d'énergie dans la vallée principale $\Gamma$, caractérisée par une constante de temps $\tau_\varepsilon$. Les relaxations intravallée (L) ou intervallées $(\Gamma) \leftrightarrow (L)$ et $(L) \leftrightarrow (L)$ sont plus rapides. Il en résulte que les électrons des vallées (L) se thermalisent avec le réseau en un temps court par rapport à $\tau_\varepsilon$. Le partage des populations d'électrons entre les vallées $(\Gamma)$ et (L) s'établit aussi presque instantanément par rapport à $\tau_\varepsilon$. La relaxation d'énergie de l'ensemble des électrons est donc subordonnée à celle de la vallée principale, ce qui conduit aux grandes énergies, à un temps de relaxation effectif plus long que $\tau_\varepsilon$. En effet pour une énergie moyenne, de l'ordre de l'énergie de transfert, $n_L/n_\Gamma$ est de l'ordre de $d_L/d_\Gamma$, où $d_L$ et $d_\Gamma$ sont les densités des niveaux (L) et $(\Gamma)$, d'où un temps de relaxation effectif décrit par B.K RIDLEY dans "Anatomy of the transferred-electron effect in III.V semiconductors", Y.A.P., vol.48 Nb 2, 1977:

$$(\tau_\varepsilon)_{eff} = \tau_\varepsilon \; \frac{d_\Gamma + d_L}{d_\Gamma} \quad \text{voisin de } 3\tau_\varepsilon$$

voisin de $3\tau$

Les valeurs données sont $(\tau_\varepsilon)_{eff} = 3$ ps pour le GaAs, 1,5 ps pour l'InP, soit des fréquences de coupures respectives de 50 GHz et 100 GHz. Pour une énergie moyenne comprise entre l'écart d'énergie $\varepsilon_{\Gamma L}$ et l'énergie du phonon optique $\varepsilon_{ph}$, de telle sorte que le nombre d'électrons dans les vallées L soit très inférieur au nombre d'électrons dans la vallée $\Gamma$ et que l'absorption de phonons optiques soit négligeable par rapport à l'émission, $\tau_\varepsilon$ a pour ordre de grandeur $\tau_{ph}(\varepsilon - \varepsilon_\Gamma)/\varepsilon_{ph})$, où $\tau_{ph} = 0,13$ ps est le temps de collision électron-phonon optique, $\varepsilon_{ph} = 0,035$ eV pour le GaAs.

La courbe en trait plein de la figure 3 représente la caractéristique dynamique courant-tension d'une diode millimétrique oscillant en mode d'accumulation comme décrit par H.D.Rees dans "Hot Electron Devices for millimetre and submillimetre Applications", Proc. of Hot carriers Conference, Montpellier, July 7-10, 1981. Elle montre l'effet de ces constantes de temps qui se traduit par un déphasage courant-tension important, d'où une baisse des performances de la diode en hyper fréquence. Pendant la demi-alternance où V(t) diminue, le courant se maintient à une valeur faible par rapport au courant de la caractéristique de volume. Cet écart est lié au retard à la rethermalisation: les électrons stagnent dans la vallée (L) à faible mobilité alors que le champ diminue. Cet effet montre aussi que les seuls modes possibles en millimétrique sont des modes de transit: le seul moyen de disposer d'électrons rethermalisés est de les évacuer par l'anode.

- Une "zone morte" se forme à l'avant de la cathode, liée à la nature du contact et aux mécanismes de relaxation. Un électron libéré par la cathode doit parcourir une certaine distance dans le sens du champ pour acquérir l'énergie de transfert $\varepsilon_{\Gamma L}$. Cet espace où l'électron absorbe de l'énergie, équivaut à une résistance de pertes qui dégrade la puissance HF et le rendement. L'effet de la zone morte est d'autant plus nocif que sa longueur $\underline{d}$ est plus grande par rapport à celle de la région active l. $\underline{d}$ est fonction de la nature du matériau et du contact. D'autre part l est proportionnel à 1/f pour un mode de transit. L'effet de la zone morte s'aggrave donc quand la fréquence augmente. Les bons résultats obtenus avec des contacts limitants sont liés, probablement pour une large part, à leur zone morte plus courte, le champ étant maximum à la cathode et relativement uniforme, alors que pour un contact ohmique, le champ est nul à la cathode. Les meilleures performances de l'InP, par rapport au GaAs, s'expliquent aussi, dans une certaine mesure, par une zone morte plus courte. On obtient un ordre de grandeur de d en supposant le parcours balistique dans un champ constant $E = E_c$. D'où

$$d = \frac{\varepsilon_{\Gamma L}}{q \cdot E_c}$$

soit d = 1 μm pour le GaAs et d = 0,5 μm pour l'InP.

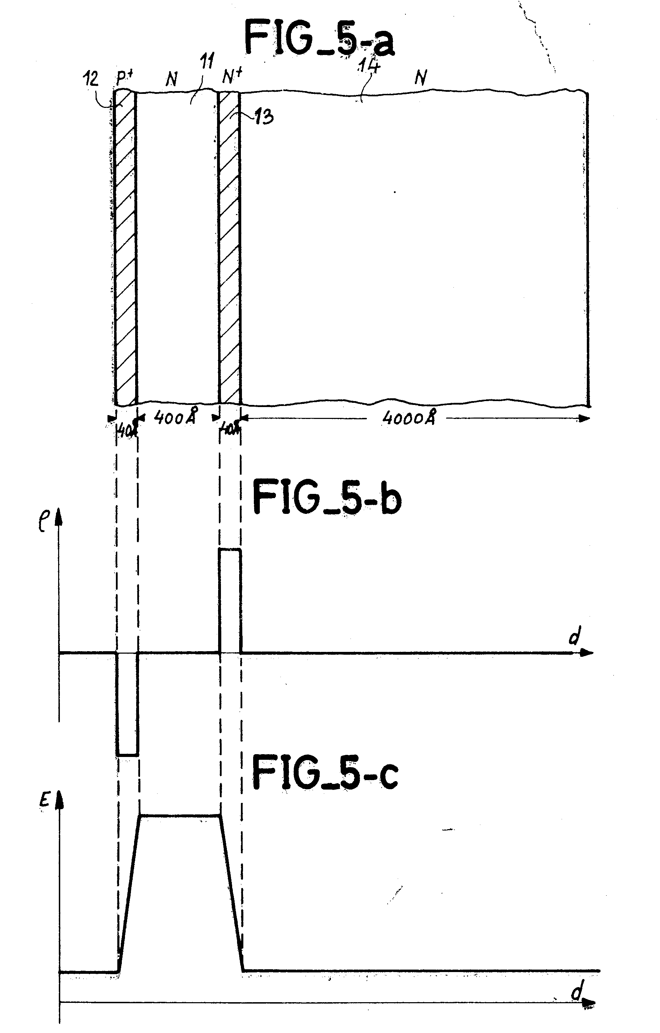

Le schéma de la diode selon l'invention qui permet de remédier aux inconvénients développés ci-dessus est représenté sur la figure 4. Cette diode est constituée par une structure périodique comportant sur un substrat dopé N$^+$ ,1, d'épaisseur comprise entre 20 et 100 μm par exemple comportant éventuellement une couche épitaxique tampon N$^+$ , muni sur l'autre face d'une couche métallique formant la cathode K de la diode. Le substrat est recouvert d'une couche d'entrée dopée N,2, ayant une épaisseur de l'ordre de 1000 Å par exemple, puis d'une succession de cellules élémentaires, 10, 20, 30... La dernière cellule est recouverte d'une couche conductrice métallique formant le contact d'anode A. La figure 5a représente une cellule élémentaire. Chaque cellule élémentaire comporte une région dopée N, 11, courte, "balistique" de quelques centaines d'Ångströms, délimitée par deux couches fortement dopées P$^+$ et N$^+$ très minces (20 à 50 Å) respectivement 12 et 13 et suivie d'une région de transit de matériau homogène N, 14, plus longue (0,3 à 0,5 μm). Les couches P$^+$ et N$^+$ sont complètement déplétées d'où les profils de charge $\varrho$ et de champ E représentés sur les figures 5b, 5c. La région courte 12 est une région balistique où l'électron acquiert une énergie élevée en un temps t inférieur au temps de relaxation de la quantité de mouvement $\tau_m$. Il convient de signaler qu'une structure comportant une telle région courte balistique a été décrite par Y.A. Cooper et al dans un article intitulé "Semiconductor structures for repeated Velocity Overshoot", IEEE electron Device letters Vol. EDL.3 n°12, 1982, dans le but de produire une survitesse électronique: les électrons sont soumis successivement à une accélération balistique suivie d'une rethermalisation, ce qui donne théoriquement, dans l'arsenium de gallium GaAs, une vitesse moyenne de l'ordre de quatre fois la vitesse de saturation. La région courte balistique est utilisée dans la structure selon l'invention, pour créer une résistance négative pendant toute la durée du cycle HF : moyennant des caractéristiques physiques et des conditions de polarisation légèrement différentes expliquées ci-après.

Avant de décrire le fonctionnement de cette nouvelle diode, il convient de préciser ces paramètres physiques et les principales conditions auxquelles cette structure doit satisfaire:

1) la région courte 11 doit être balistique pour un champ électrique $E_0$ tel que l'électron soit accéléré à l'énergie de transfert $\varepsilon_{\Gamma L}$ après avoir traversé cette région, soit $\varepsilon_{\Gamma L} = qE_0 d$, où d est la longueur de la région balistique 1, et $t_b$ inférieur à $\tau_{ph}$ où $t_b$ est le temps de transit balistique et $\tau_{ph}$ est le temps de collision électron-phonon (0,13 ps pour le GaAs comme indiqué ci-dessus). $t_b$ est donné, en négligeant l'écart à la parabolicité, par:

$$t_b = \left( \frac{2m^*}{\varepsilon_{\Gamma L}} \right)^{\frac{1}{2}} \cdot d,$$

où m* est la masse effective des électrons.

2) la charge des régions désertes 12 dopée P$^+$ et 13 dopée N$^+$ doit être ajustée de telle sorte qu'en polarisant la région balistique au champ $E_0$, le champ $E_1$ dans la région de transit 14 soit proche et légèrement inférieur au champ critique $E_c$.

3) la région de transit 14 doit être assez longue pour qu'un électron qui entre dans cette région avec l'énergie $\varepsilon_{\Gamma L}$ (il peut s'agir d'un électron dans la vallée $(\Gamma)$ ou $(L)$) soit thermalisé durant son parcours, de telle sorte qu'il aborde la région balistique suivante avec une énergie moyenne indépendante de la position de cette région balistique dans la structure complète; ainsi les conditions aux limites d'une cellule à l'autre sont semblables.

Le fonctionnement d'une telle structure est alors le suivant:

lorsqu'une cellule de la structure est soumise à une tension de la forme $V_0 + \bar{V} \cos \omega t$, il en résulte, dans la région balistique, en négligeant l'effet de la charge d'espace électronique, un champ E(t) de la forme $E_0 + \bar{E} \cos \omega t$, où $E_0$ est défini par la condition

$$E_o = \frac{\mathcal{E}_{\sqcap L}}{qd}.$$

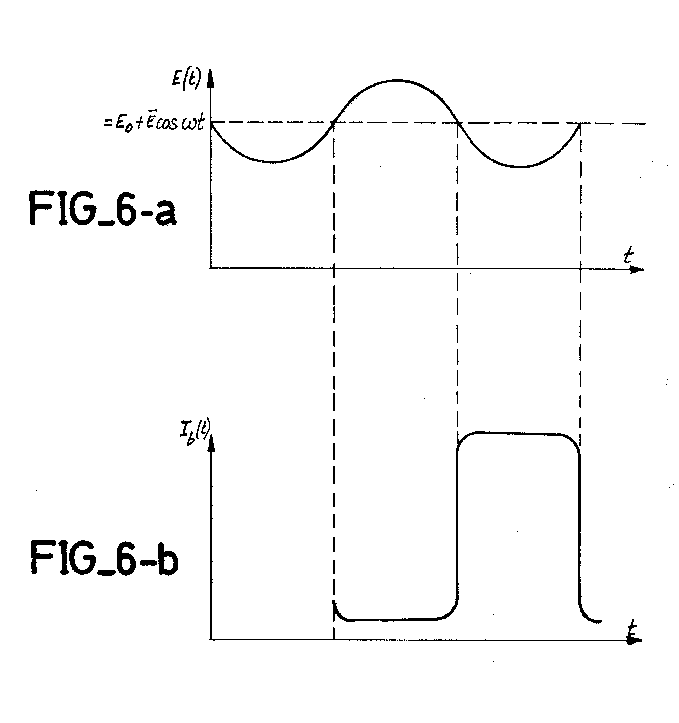

Ce champ est représenté sur la figure 6a. Le courant émis par la région balistique $I_b(t)$ a l'allure indiquée sur la figure 6b. En effet pendant la demi-alternance positive, les électrons acquièrent une énergie supérieure à $\mathcal{E}_{\sqcap L}$: sous l'effet du champ, l'énergie des électrons dans la sous-bande ($\sqcap$) augmente, en suivant la caractéristique d'énergie de la figure 1, du point M au point P. Dès que ce point P est atteint, les électrons passent dans la sous-bande (L), en raison du poids statistique élevé de cette sous-bande. La majorité des électrons est donc transférée dans la vallée (L) où ils se thermalisent quasi-instantanément avec le réseau. Ils entrent dans la région de transit avec la mobilité $\mu_L$ très inférieure à $\mu_{\sqcap}$. Si l'on admet que $\mu_{\sqcap} = 0,6$ m²/Vs, et que $\mu_L = \mu_{\sqcap}/15 = 0,04$ m²/Vs, et avec un champ critique de l'ordre de $E_c = 3,2 \cdot 10^5$ V/m, la vitesse des électrons à l'entrée de la région de transit pendant la demi-alternance positive est v' à peu près égale à $\mu_L E_c$ soit $1,3 \cdot 10^4$ m/s. Pendant la demi-alternance négative, les électrons n'atteignent pas l'énergie de seuil, pour la majorité d'entre eux. Ils restent dans la vallée ($\sqcap$) à haute mobilité. Ils entrent alors dans la région de transit avec une vitesse

$$v'' = \left( \frac{2 \mathcal{E}^*}{m^*} \right)^{1/2}$$

ou $\mathcal{E}^*$ est inférieur mais peu différent de L'énergie de seuil, soit $v'' = 1,35 \cdot 10^6$ m/s, v'' voisin de 100 fois v'. En fait, pour une énergie de cet ordre, l'écart de parabolicité de la vallée ($\sqcap$) n'est pas négligeable, d'où une valeur de v'' un peu plus faible de l'ordre de $10^6$ m/s.

La région balistique délivre donc un courant électronique $I_b(t)$ en opposition de phase avec la tension, avec un indice de modulation très important. Grâce au champ élevé dans cette région ($E_o$ est dix à vingt fois plus grand que le champ critique $E_c$), la zone morte est pratiquement supprimée, et le temps d'accélération jusqu'à l'énergie de seuil, $\tau_a(E_o)$, est négligeable puisque $\tau_a(E_o) = t_b$ et inférieur à $\tau_{ph} = 0,13$ ps dans le cas du GaAs, ce qui est très inférieur au temps correspondant pour la diode Gunn classique. Pour celle-ci en effet, le temps d'accélération à l'énergie critique, $\tau_a(E_c)$ est environ 10 à 20 fois plus grand que $\tau_a(E_o)$. Le temps réellement nécessaire pour l'acquisition de l'énergie de seuil est encore plus grand parce que $\tau_a(E_c)$ est très supérieur à $\tau_{ph}$ ce qui implique que l'énergie de seuil ne peut être atteinte, pour $E = E_c$, par une simple accélération balistique, mais plutôt par accroissement de l'énergie désordonnée (éventuellement assimilable à une "température électronique") en raison du rôle important des collisions dans ces conditions. La nouvelle structure permet donc une amélioration très nette des limitations en fréquence.

La région de transit a pour fonction de permettre la relaxation de la quantité de mouvement et de l'énergie, ce qui entraîne des conditions sur le champ dans cette région $E_{tr}$ et sur la longueur de cette région:

- le champ $E_{tr}$ doit être inférieur au champ critique à tout instant pour que la région de transit ne contribue pas de manière significative au peuplement de la vallée (L). $E_{tr}$ très proche du champ critique serait acceptable. En effet, au moment où débute la demi-alternance positive, il se forme, à l'entrée de la région de transit, une zone déplétée, puisque à cet instant des électrons rapides précèdent des électrons lents, ce qui conduit à un dégroupement; d'où un profil de champ analogue à celui d'un contact limitant, à savoir un champ qui décroît dans la région de transit de l'entrée vers la sortie. Vers le début de la demi-alternance négative, il se forme au contraire une zone d'accumulation, d'où un profil de champ incliné dans le sens opposé.

- La longueur de la région de transit 14 doit être suffisante et tout juste suffisante pour qu'un électron, au cours de sa traversée, puisse relaxer sa quantité de mouvement et son énergie. Il faut examiner séparément ce qui se passe pendant chaque demi-alternance, parce que les temps de transit ainsi que les temps de relaxation sont différents. Pendant la demi-alternance négative, dans le cas de GaAs, pour $\tau_m = 0,25$ ps et $\tau_{\mathcal{E}} = 1$ ps, la longueur minimum de la région de transit compatible avec une rethermalisation complète est 4000 Å et, pour cette longueur, la vitesse moyenne est $4 \cdot 10^5$ m/s. Pendant la demi-alternance positive, la relaxation fait intervenir les deux vallées ($\sqcap$) et (L). Suivant les remarques faites ci-dessus, le temps de relaxation de l'énergie est alors de l'ordre de $\tau_{\mathcal{E} \, eff} = 3$ ps. Au cours de ce temps, la vitesse électronique passe progressivement de $\mu_L E_c$ de l'ordre de $10^6$ cm/s à $\mu_{\sqcap} E_c$ de l'ordre de $10^7$ cm/s. La distance parcourue par un électron pendant le temps $\tau_{\mathcal{E} \, eff} = 3$ ps est alors de l'ordre de 1 500 Å. En conclusion on devra prendre la plus grande des deux distances pour la longueur de la région de transit, soit 4 000 Å.

Pour expliquer le choix des paramètres physiques et le mode de réalisation, le cas du GaAs est donné à titre d'exemple non limitatif. La transposition à l'InP s'en déduit.

Les paramètres de la région balistique sont définis par les relations précisées ci-dessus: $\mathcal{E}_{\sqcap L} = qE_o \, d$ et $t_b$

$$= \left( \frac{2m^*}{\mathcal{E}_{\sqcap L}} \right)^{1/2} \cdot d,$$

soit: $t_b = 1,47 \cdot 10^{-6}$ .d. La condition de régime balistique. $t_b$ inférieur à $\tau_{ph}$ donne ensuite: d inférieur à $8,8 \cdot 10^{-8}$ m. L'indice de modulation du courant est une fonction croissante de $E_o^{-1}$, c'est-à-dire de d. On choisit donc pour d une valeur élevée tout en étant raisonnablement compatible avec la condition balistique, soit $d = 5.10^{-8}$ m, d'où on déduit le champ : $E_0 = \varepsilon_r \, L/qd = 6,6.10^6$ V/m. La charge des régions $P^+$ et $N^+$ est donnée en supposant $P^+ = N^+ = N_c$ et des épaisseurs égales, $\delta$, petites par rapport à $d$ par : $N_c \, \delta = (E_0 - E_c) \varepsilon_0 \, \varepsilon_r/q = 4,34.10^{15}$ m$^{-2}$, c'est-à-dire $N_c$ supérieur à $0,87.10^{23}$ m$^{-3}$. En prenant $N_c = 10^{24}$ m$^{-3}$, cette condition est largement satisfaite et l'épaisseur $\delta$ est alors de l'ordre de 50 Å.

La longueur $l$ de la région de transit a été déterminée plus haut, $l$ est de l'ordre de 4.000 Å. Le dopage devrait être de l'ordre de $5.10^{21}$ m$^{-3}$ à $10^{22}$ m$^{-3}$ pour une fréquence de l'ordre de 90 GHz. Ce dopage est plus faible que celui d'une diode Gunn avec un contact $N \pm N$, à la même fréquence, car dans ce dernier cas, la formation du domaine d'accumulation doit être suffisamment rapide, et le taux de croissance du domaine est proportionnel au dopage. Les avantages d'un dopage plus faible (c'est le cas des diodes à contact limitant) sont une dissipation thermique meilleure, une impédance négative plus grande ce qui conduit à des pertes HF plus faibles.

Pour minimiser les pertes, il faut d'une part réduire les pertes de circuit métalliques en utilisant une résistance de charge élevée et d'autre part réduire les pertes liées à la diode elle-même, c'est-à-dire à la fois les pertes liées aux contacts métallisation-substrat et celles dues à l'effet de zone morte dans la couche d'entrée de la diode.

Pour obtenir ce résultat, selon le mode préféré de réalisation décrit en référence à la figure 4, plusieurs cellules élémentaires sont mises en série. Ainsi les effets de zone morte et de pertes dans le substrat affectent une résistance négative plus élevée, ce qui en proportion amoindrit leur effet.

La limitation dans le nombre de cellules élémentaires susceptibles d'être mises en série est liée d'une part à la reproductibilité lors de la fabrication (précision sur les dopages et les dimensions) et d'autre part à la résistance thermique de l'ensemble qui bien sûr ne doit pas être trop élevée.

Le nombre de cellules élémentaires est tel qu'il réalise un compromis satisfaisant entre la résistance thermique et l'impédance négative. On est ainsi conduit à une structure qui, dans le meilleur mode de réalisation comporte 3, voire 4 cellules.

Mais une diode qui ne comporterait qu'une cellule élémentaire pourrait dans certaines utilisations être suffisante.

Pour la fabrication des diodes selon l'invention la méthode de croissance la plus appropriée pour les couches semi-conductrices est l'épitaxie à jets moléculaires pour le GaAs, l'épitaxie gazeuse organométallique pour l'InP. Ces méthodes connues ne sont évidemment pas limitatives.

**Revendications**

1. Diode à transfert d'électrons comportant un substrat semi-conducteur dopé $N^+$ (1) dont une face est munie d'un contact métallique formant la cathode (K) et dont l'autre face est recouverte d'une couche d'entrée de semi-conducteur dopée N suivie d'une structure semi-conductrice active munie d'un contact métallique formant l'anode (A), caractérisée en ce que la structure semi-conductrice comporte au moins une cellule élémentaire (10) comportant une région courte balistique (11) dopée N, entre deux couches semi-conductrices très minces (12, 13), fortement dopées respectivement $P^+$ et $N^+$, et une région de transit (14) dopée N, plus longue, la région balistique (11) permettant d'amener les électrons à un niveau d'énergie élevé dans un temps inférieur au temps de collision, et la région de transit permettant de ramener l'énergie électronique, par relaxation avec le réseau, à une valeur très inférieure à l'énergie de transfert.

2. Diode selon la revendication 1, caractérisée en ce que la structure semi-conductrice est une structure périodique qui comporte une succession de cellules élémentaires (10, 20, 30).

3. Diode selon l'une des revendications 1 et 2, caractérisée en ce que le matériau semi-conducteur utilisé pour constituer la diode étant l'arseniure de gallium, la région balistique (11) de chaque cellule élémentaire a une épaisseur de l'ordre de 400 Å, les couches de limitation (12, 13) respectivement dopées $P^+$ et $N^+$, ayant une épaisseur de l'ordre de 40 Å, tandis que la région de transit (14) a une épaisseur de l'ordre de 4000 Å

4. Diode selon l'une des revendications 1 et 2, caractérisée en ce que le matériau semi-conducteur utilisé pour constituer la diode est le phosphure d'indium.

0252818

# FIG_1

# FIG_2

## FIG_3

## FIG_4

0252818

# FIG_5-a

# FIG_5-b

# FIG_5-c

$$= E_0 + \bar{E}\cos\omega t$$

$E(t)$

$t$

## FIG_6-a

$I_b(t)$

$t$

## FIG_6-b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | INTERNATIONAL ELECTRON DEVICES MEETING - IEDM Technical Digest, Washington, D.C., 8-10 décembre 1980, pages 456-459, Electron Devices Society of IEEE; R.J. MALIK et al.: "GaAs planar doped barriers by molecular beam epitaxy" * Page 458, paragraphe: "Applications" * | 1 | H 01 L 47/02 H 01 L 29/36 |
| D,A | IEEE ELECTRON DEVICE LETTERS, vol. EDL-3, no. 12, décembre 1982, pages 407-408, IEEE, New York, US; J.A. COOPER, Jr. et al.: "Semiconductor structures for repeated velocity overshoot" * Page 408, colonne 1, lignes 32-41 * | 1 | |
| A | US-A-4 539 581 (R.J. MALIK et al.) * Résumé; figure 1 * | 1 | DOMAINES TECHNIQUES RECHERCHES (Int. Cl.4) H 01 L |

Le présent rapport de recherche a été établi pour toutes les revendications

| Lieu de la recherche | Date d'achèvement de la recherche | Examinateur |
|---|---|---|
| LA HAYE | 14-10-1987 | PELSERS L. |